# EUROPEAN PATENT APPLICATION

(11) **EP 2 555 249 A1**
(43) Date of publication of application: **06.02.2013**
(21) Application number: 11765551.4
(22) Date of filing: 29.03.2011
(51) Int. Cl.: H01L 31/04

(54) **SOLAR PANEL INSPECTION DEVICE, SOLAR PANEL INSPECTION METHOD, SOLAR PANEL MANUFACTURING METHOD, AND SOLAR PANEL**

(30) Priority: 31.03.2010 JP 2010082942
(71) Applicant: Sharp Kabushiki Kaisha, Osaka-shi, Osaka 545-8522 (JP)
(72) Inventor: TACHIBANA, Shinsuke, Osaka-shi, Osaka 545-8522 (JP); HIRATA, Shigeo, Osaka-shi, Osaka 545-8522 (JP)
(74) Representative: Müller - Hoffmann & Partner
(86) International application number: PCT/JP2011/057814
(87) International publication number: WO 2011/125651

(57) **Abstract**

The solar cell panel inspection device comprises a housing (51), a first terminal (31) for abutting against a back-side electrode layer (5), a second terminal (32) for abutting against a region in proximity to an outer peripheral end of an outer peripheral insulating area (21), a mechanism moving first terminal (31) and second terminal (32) vertically and horizontally, a voltage applying section (34) for applying voltage respectively between first terminal (31) and second terminal (32), a current detecting section (35) for detecting a current flowing between first terminal (31) and second terminal (32) applied with voltage by voltage applying section (34), means (36) for regulating moisture amount in housing (51), and means (37) for reducing moisture amount in housing (51).

## Description

### TECHNICAL FIELD

The present invention relates to a solar cell panel inspection device, a method for inspecting a solar cell panel, a method for manufacturing a solar cell panel, and a solar cell panel.

### BACKGROUND ART

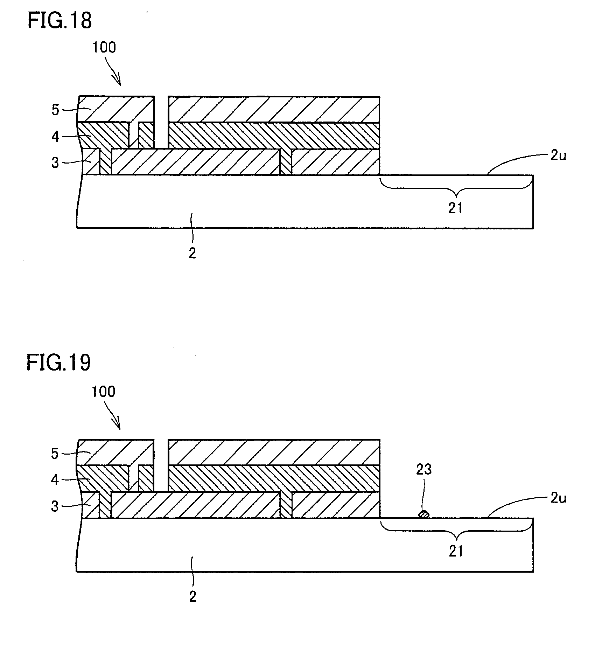

A conventional solar cell panel has a structure as disclosed in Japanese Patent Laying-Open No. 2008-109041 (Patent Literature 1). Focusing on one example of the solar cell panel disclosed in the Patent Literature 1, an enlarged cross-sectional view depicting the vicinity of an end of the solar cell panel is shown in Fig. 18. A solar cell panel 100 includes a transparent insulating substrate 2 having a main surface 2u, with a transparent electrode layer 3, a semiconductor photoelectric conversion layer 4, and a back-side electrode layer 5 sequentially stacked on main surface 2u of transparent substrate 2. Solar cell panel 100 has an outer peripheral insulating area 21 located in proximity to an outer periphery of transparent insulating substrate 2 and exposing main surface 2u of transparent insulating substrate 2.

### CITATION LIST

### PATENT LITERATURE

PTL 1: Japanese Patent Laying-Open No.2008-109041

### SUMMARY OF INVENTION

### TECHNICAL PROBLEM

The structure shown in Fig. 18 is fabricated by forming each layer and then patterning the layers by means of laser, blasting, or the like generally used. This structure is entirely sealed by a resin (not shown) and a protective film after the fabrication.

As shown in Fig. 18, main surface 2u of transparent insulating substrate 2 is directly exposed at outer peripheral insulating area 21, thus there should be nothing present on main surface 2u. However, as shown in Fig. 19, a residue 23 of some kind of material at the time of patterning may in fact remain on outer peripheral insulating area 21.

In the case of sealing the entirety with a resin, such a residue 23 is also sealed together. Since a test for evaluating a breakdown voltage is conducted to ship only an accepted product after connecting with a resin and a protective film and/or a terminal box, eventually a defective product may also proceed to the sealing step.

Therefore, in order to avoid such an unintentional determination of a defective product, it is effective to conduct an inspection using an inspection device once after forming outer peripheral insulating area 21. Inspecting the presence of a residue on the main surface of the outer peripheral insulating area before obtaining a completed product can prevent waste of subsequent module material.

A substrate of a solar cell panel having failed the insulation breakdown voltage test during the manufacturing process was analyzed. However, it was found that there was a substrate presenting no cause of insulation failure. Further, the substrate was inspected again using a solar cell panel inspection device, but it was found that the state of insulation was favorable. As a result of attempts to find out the cause, attention was focused on the causal relationship between the absolute moisture amount (recited as "moisture amount" in the specification) in the solar cell panel inspection device and the moisture amount in the line to arrive at the present invention.

Thus, an object of the present invention is to provide a solar cell panel inspection device for accurately inspecting the state of insulation at an outer peripheral insulating area of a solar cell panel, a method for inspecting a solar cell panel, a method for manufacturing a solar cell panel, and a solar cell panel.

### SOLUTION TO PROBLEM

To achieve the object described above, a solar cell panel inspection device in accordance with the present invention is for conducting inspection with respect to a solar cell panel. The solar cell panel includes a transparent electrode layer, a photoelectric conversion layer, and a back-side electrode layer sequentially stacked on a main surface of a transparent insulating substrate, and having an outer peripheral insulating area located in proximity to an outer periphery of the transparent insulating substrate and exposing the main surface of the transparent insulating substrate. The solar cell panel inspection device is for inspecting insulation performance of the outer peripheral insulating area. The solar cell panel inspection device includes a housing accommodating a solar cell panel subject to inspection, a first terminal for abutting against the back-side electrode layer, a second terminal for abutting against a region in proximity to an outer peripheral end of the outer peripheral insulating area, a voltage applying section applying voltage respectively between the first terminal and the second terminal, a current detecting section detecting a current flowing between the first terminal and the second terminal applied with voltage by the voltage applying section, and means for reducing moisture amount in the housing.

To achieve the object described above, a method for inspecting a solar cell panel in accordance with the present invention is for conducting inspection with respect to a solar cell panel. The solar cell panel includes a transparent electrode layer, a photoelectric conversion layer, and a back-side electrode layer sequentially stacked on a main surface of a transparent insulating substrate, and having an outer peripheral insulating area located in proximity to an outer periphery of the transparent insulating substrate and exposing the main surface of the transparent insulating substrate. The method is for inspecting insulation performance of the outer peripheral insulating area. The method includes the steps of reducing moisture amount in an atmosphere around the solar cell panel subject to inspection, and detecting a current flowing between the back-side electrode layer and a region in proximity to an outer peripheral end of the outer peripheral insulating area after the step of reducing the moisture amount.

To achieve the object described above, a method for manufacturing a solar cell panel in accordance with the present invention includes the steps of stacking a photoelectric conversion layer and a back-side electrode layer on a transparent electrode layer provided at a transparent insulating substrate, forming an outer peripheral insulating area by removing the transparent electrode layer, the photoelectric conversion layer, and the back-side electrode layer stacked in proximity to an outer periphery of the transparent insulating substrate, reducing moisture amount in an atmosphere around the transparent insulating substrate, and inspecting insulation performance of the outer peripheral insulating area by detecting a current flowing between the back-side electrode layer and a region in proximity to an outer peripheral end of the outer peripheral insulating area after the step of reducing the moisture amount.

To achieve the object described above, a solar cell panel in accordance with the present invention is manufactured using the above-described method for inspecting a solar cell panel and the above-described method for manufacturing a solar cell panel.

### ADVANTAGEOUS EFFECTS OF INVENTION

According to the present invention, the voltage is applied between terminals, and the amount of current is accurately inspected, so that the state of insulation in the outer peripheral insulating area of the solar cell panel can be inspected accurately. Thus, the productivity of solar cell panels can be improved.

### BRIEF DESCRIPTION OF DRAWINGS

Fig. 1 represents a construction of a solar cell panel inspection device in accordance with a first embodiment.
Fig. 2 represents a cross-sectional structure of a solar cell panel.
Fig. 3 is a partially enlarged a cross-sectional view of the solar cell panel inspection device in accordance with the first embodiment 1, where a terminal is located in the outer peripheral insulating area of the solar cell panel.
Fig. 4 is a graph showing a relationship between the temperature and the moisture amount with respect to a constant humidity (50%).
Fig. 5 represents constructions of a solar cell panel inspection device and an upstream side device in accordance with a second embodiment.
Fig. 6 is a plan view of positions of the terminals in the solar cell panel inspection device in accordance with the Example 1.
Fig. 7 is a cross sectional view for describing a positional relationship between the solar cell panel inspection device and the solar cell panel and the applied voltage in accordance with the Example 1.
Fig. 8 is a graph showing a relationship between the current leakage and the moisture amount due to the applied voltage of 6000V.
Fig. 9 is a schematic cross-sectional view for describing the first step of manufacturing the solar cell panel in accordance with the Example 1.
Fig. 10 is a schematic cross-sectional view for describing the second step of manufacturing the solar cell panel in accordance with the Example 1.
Fig. 11 is a schematic cross-sectional view for describing the third steps of manufacturing the solar cell panel in accordance with the Example 1.
Fig. 12 is a schematic cross-sectional view for describing the fourth step of manufacturing the solar cell panel in accordance with the Example 1.
Fig. 13 is a schematic cross-sectional view for describing the fifth step of manufacturing the solar cell panel in accordance with the Example 1.
Fig. 14 is a schematic cross-sectional view for describing the sixth step of manufacturing the solar cell panel in accordance with the Example 1.
Fig. 15 is a schematic cross-sectional view for describing the seventh step of manufacturing the solar cell panel in accordance with the Example 1.
Fig. 16 is a schematic cross-sectional view for describing the eighth step of manufacturing the solar cell panel in accordance with the Example 1.
Fig. 17 is a schematic cross-sectional view for describing the ninth step of manufacturing the solar cell panel in accordance with the first embodiment.
Fig. 18 is a first view of a cross-sectional structure of the solar cell panel.
Fig. 19 is a second view of a cross-sectional structure of the solar cell panel.

### DESCRIPTION OF EMBODIMENTS

A solar cell panel inspection device, a method for inspecting a solar cell panel, a method for manufacturing a solar cell panel, and a solar cell panel in accordance with each embodiment of the present invention will be described below with reference to the drawings. It should be noted that the embodiments and examples described below are mere examples, thus the present invention can be practiced with various embodiments and examples within the scope of the invention.

Further, in the embodiments described below, even when the number and amount are mentioned, the scope of the present invention is not necessarily limited to the described number and amount unless specifically noted. Further, the same parts and corresponding parts have the same reference numeral allotted, and the description thereof will not be repeated.

### (First Embodiment)

### (Construction of Solar Cell Panel Inspection Device 50)

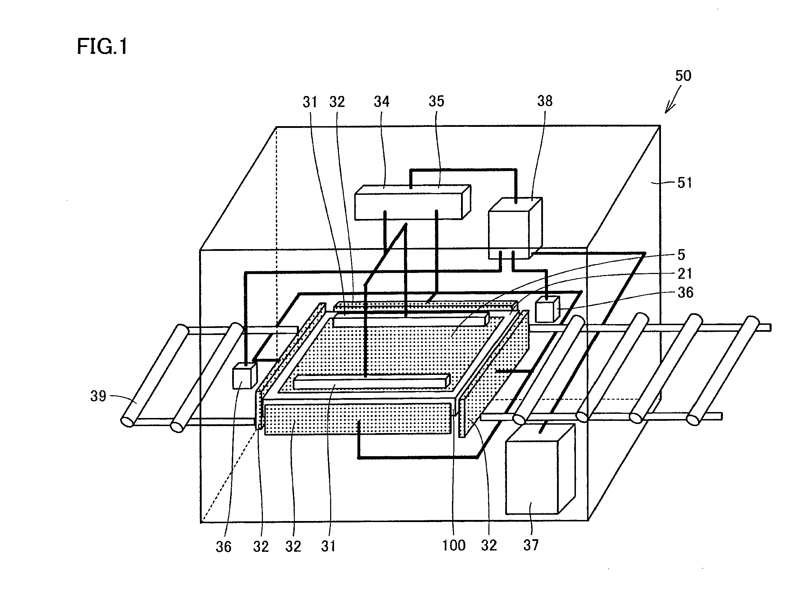

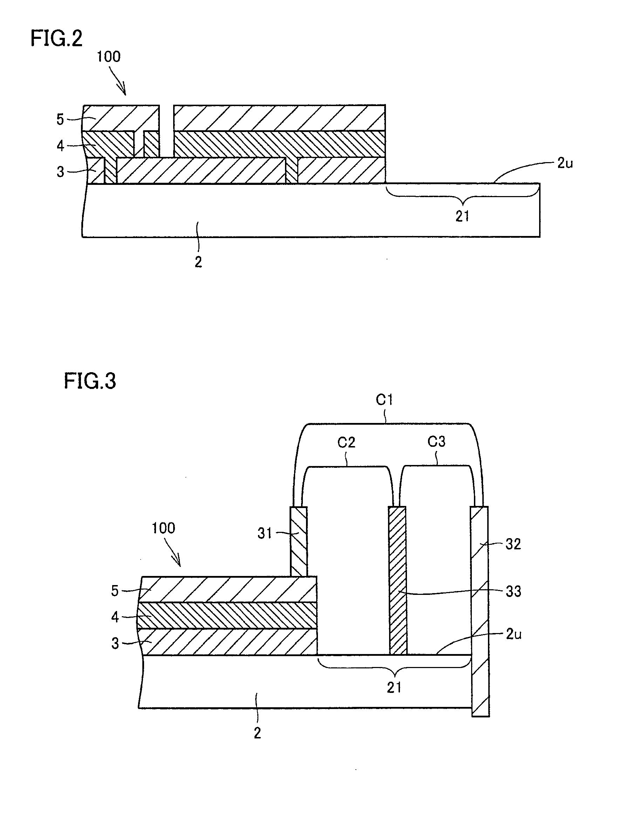

As shown in Fig. 1, an exemplary construction of a solar cell panel inspection device 50 in accordance with the present embodiment will be described. As shown in Fig. 2, a solar cell panel 100 subject to an inspection conducted by this solar cell panel inspection device 50 includes a transparent insulating substrate 2 having a main surface 2u, with a transparent electrode layer 3, a semiconductor photoelectric conversion layer 4, and a back-side electrode layer 5 sequentially stacked on main surface 2u of transparent insulating substrate 2, and has an outer peripheral insulating area 21 located in proximity to an outer periphery of transparent insulating substrate 2 and exposing main surface 2u. Solar cell panel inspection device 50 is for conducting an inspection with respect to solar cell panel 100 to inspect insulation performance of outer peripheral insulating area 21.

Referring to Fig. 1 again, this solar cell panel inspection device 50 includes a housing 51, first terminals 31 for abutting against back-side electrode layer 5, second terminals 32 for abutting against a region in proximity to an outer peripheral end of outer peripheral insulating area 21, a mechanism (not shown) moving first terminals 31 and second terminals 32 vertically and horizontally, a voltage applying section 34 applying the voltage respectively between first terminals 31 and second terminals 32, a current detecting section 35 (for example, an insulation breakdown voltage testing machine) detecting a current flowing between first terminals 31 and second terminals 32 applied with the voltage by voltage applying section 34, means 36 (for example, a temperature-humidity sensor) for regulating the moisture amount in housing 51, and means 39 (for example, a conveyer) for conveying solar cell panel 100.

In housing 51, while solar cell panel 100 subject to inspection is accommodated, means 36 for regulating the moisture amount can regulate the moisture amount in the atmosphere around solar cell panel 100, and means 37 for reducing the moisture amount can reduce the moisture amount in the atmosphere around solar cell panel 100.

Voltage applying section 34 and current detecting section 35 detecting a current may be integrated. Means 36 for regulating the moisture amount and means 37 for reducing the moisture amount in housing 51 may also be integrated. Further, means 36 for regulating the moisture amount is not necessarily an essential part of the device construction. For example, there is a case where the reduction of the moisture amount in housing 51 can be confirmed by confirming the operation of means 37 for reducing the moisture amount.

Further, in addition to first terminals 31 and second terminals 32 shown in Fig. 1, a third terminal 33 (plurality allowed) may be provided between first terminal 31 and second terminal 32, as shown in Fig. 3. A combination of these terminals enables application of the voltage with respect to C1, C2, and C3. However, providing too many third terminals 33 causes the structure to be complex. Further, in light of suitably arranging a space between third terminal 33 and first terminal 31 and a space between third terminal 33 and second terminal 32 with respect to a width of the outer peripheral insulating area, providing too many third terminals 33 is disadvantageous. Taking consideration of such circumstances, realistically, the number of one or more third terminals 33 is preferably equal to or less than two.

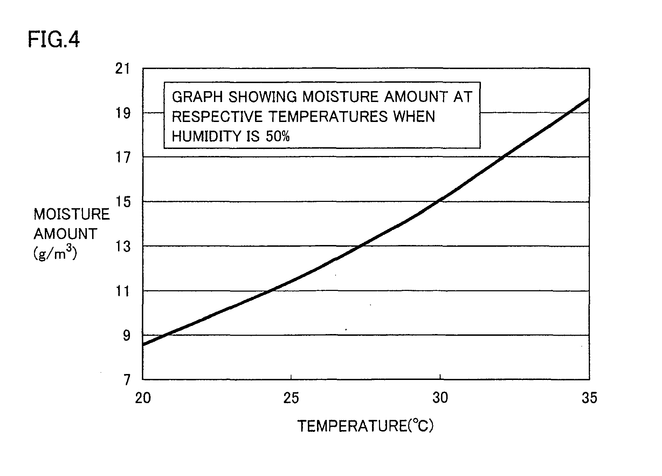

Providing at least one means 36 for regulating the moisture amount may be enough, and providing means 36 at two locations diagonally in housing 51 is preferable. As a method for regulating the moisture amount in housing 51, the moisture amount can be accurately identified by monitoring the humidity and temperature. For example, as shown in Fig. 4, even in the case where the equal humidity of 50% is present, the moisture amount is 15.05g/m³ when the temperature is 30°C, and the moisture amount is 11.42g/m³ when the temperature is 25 °C, thus the difference in the moisture amount may occur.

Further, in a manufacturing line for a solar cell panel (thin-film solar cell), the temperature regulation has a range (about 5°C), and the humidity regulation is not performed in a general manufacturing environment. Thus, regulating the humidity in accordance with the respective temperatures enables accurately identifying the moisture amount in housing 51. In that regard, the measurement can be accurately conducted by performing regulation with defined upper limits of humidity for respective temperatures.

As an easier method for regulation, when an upper limit value of the temperature regulation is provided, the measurement can be conducted correctly by regulating the humidity at the upper limit value of the temperature since the moisture amount becomes greater as the temperature is higher under the same humidity condition.

The moisture amount in housing 51 is preferably equal to or less than 14.3g/m³, more preferably, equal to or less than 12.5g/m³.

As means for reducing the moisture amount in housing 51, the moisture amount in housing 51 can be reduced by replacement with drying air. In this regard, for example, when the humidity of 50% is the upper limit value at the temperature of 25°C and, the running cost can be reduced by performing a control such as introducing the drying air when satisfying the conditions of equal to or higher than the temperature of 28°C and the humidity of 45%.

As another means for reducing the moisture amount, the moisture amount in the device can be reduced by using a dehumidifier. In this regard, for example, when the humidity of 50% is the upper limit value at the temperature of 25°C, the running cost can be reduced by performing a control such as starting operation of the dehumidifier when satisfying the conditions of equal to or higher than the temperature of 28°C and the humidity of 45%.

As means for reducing the moisture amount more easily, a system may be provided performing processes of placing a drying agent in housing 51, causing a warning sound from housing 51 if the humidity becomes equal to or higher than a specified value, and replacing the drying agent. As a drying agent, a silica gel based drying agent having a physical absorption characteristic, a calcium chloride based drying agent and a magnesium oxide based drying agent having a chemical absorption characteristic may be used. When the moisture amount is high, a drying agent having a chemical absorption characteristic superior in moisture absorption is preferably used.

Further, when the humidity, the temperature, or the moisture amount in housing 51 is equal to or higher than a prescribed value, the substrate should be allowed to take a standby state in the device, and the measurement should not be conducted until the temperature, the humidity, or the moisture amount become lower than the prescribed value. This is more preferable than allowing the substrate to wait on a conveyer or the like before being brought into the device.

### (Second Embodiment)

### (Constructions of Solar Cell Panel Inspection Device 50A and Upstream Side Device 52)

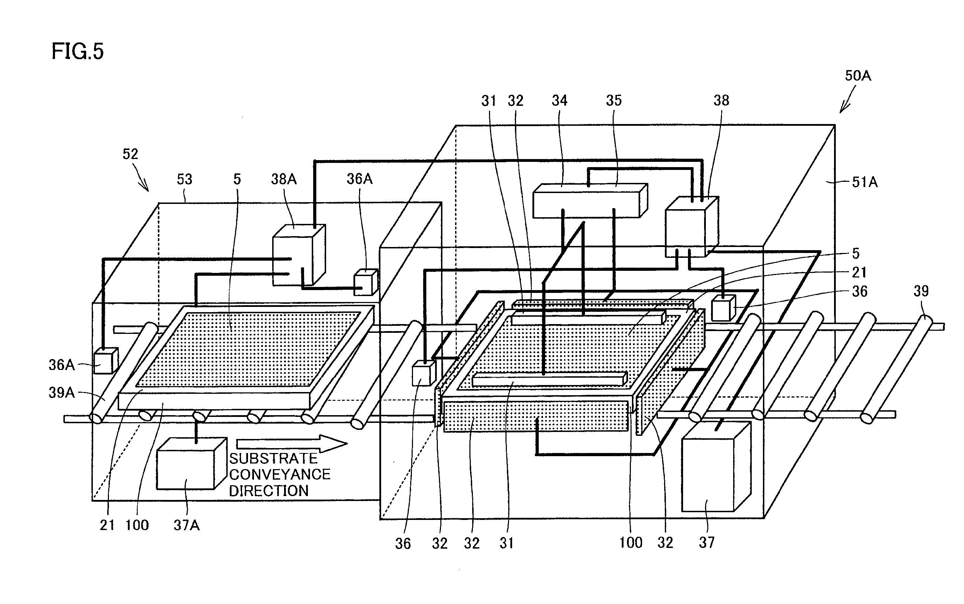

As shown in Fig. 5, an example of respective configurations of a solar cell panel inspection device 50A and an upstream side device 52 placed on upstream side in the direction of conveying solar cell panel 100, used in the present embodiment, will be described. Solar cell panel inspection device 50A is for conducting inspection with respect to solar cell panel 100, as shown in Fig. 2. The solar cell panel 100 includes transparent insulating substrate 2 having main surface 2u, with transparent electrode layer 3, semiconductor photoelectric conversion layer 4, and back-side electrode layer 5 sequentially stacked on main surface 2u of transparent insulating substrate 2, and has an outer peripheral insulating area 21 located in proximity to an outer periphery of transparent insulating substrate 2 and exposing main surface 2u. The solar cell panel inspection device 50A is for inspecting insulation performance of outer peripheral insulating area 21.

Solar cell panel inspection device 50A includes a housing 51A, first terminals 31 for abutting against at least back-side electrode layer 5, second terminals 32 for abutting against a region in proximity to an outer peripheral end of outer peripheral insulating area 21, a mechanism (not shown) moving first terminals 31 and second terminals 32 vertically and horizontally, voltage applying section 34 applying the voltage between first terminals 31 and second terminals 32, current detecting section 35 (for example, breakdown voltage and insulation resistance testing machine) detecting current flowing between first terminals 31 and second terminals 32 applied with the voltage by voltage applying section 34, means 36 (for example, a temperature-humidity sensor) for regulating the moisture amount in housing 51A, and means 39 (for example, a conveyer) for conveying solar cell panel 100.

In housing 51, while solar cell panel 100 subject to inspection is accommodated, means 36 for regulating the moisture amount can regulate the moisture amount in the atmosphere around solar cell panel 100, and means 37 for reducing the moisture amount can reduce the moisture amount in the atmosphere around solar cell panel 100.

Voltage applying section 34 and current detecting section 35 detecting a current may be integrated. Means 36 for regulating the moisture amount and means 37 for reducing the moisture amount in housing 51 may also be integrated. Further, means 36 for regulating the moisture amount is not necessarily an essential part of the device construction. For example, there is a case where the reduction of moisture amount in housing 51 can be confirmed by confirming the operation of means 37 for reducing the moisture amount.

Further, in addition to first terminals 31 and second terminals 32 shown in Fig. 5, third terminal 33 (plurality allowed) may be provided between first terminal 31 and second terminal 32 as shown in Fig. 3. A combination of the terminals enables application of the voltage with respect to C1, C2, and C3. However, providing too many third terminals 33 causes the structure to be complex. Further, in light of suitably arranging a space between third terminal 33 and first terminal 31 and a space between third terminal 33 and second terminal 32 with respect to a width of the outer peripheral insulating area, providing too many third terminals 33 is disadvantageous. Taking consideration of such circumstances, realistically, the number of one or more third terminals 33 is preferably equal to or less than two.

In a housing 53 of upstream side device 52 (for example, a conveyer) placed on immediate upstream side in the direction of conveying solar cell panel 100A, means 36A (for example, a temperature-humidity sensor) for regulating the moisture amount in housing 53 and means 37A (for example, drying air, dehumidifier, and a drying agent) for reducing the moisture amount in housing 53 are provided. Further, housing 53 accommodates a controller 38A controlling means 36A for regulating the moisture amount and means 37A for reducing the moisture amount, and means 39A (for example, a conveyer) for conveying solar cell panel 100A.

Means 37A for reducing the moisture amount may also serve as means 37 for reducing the moisture amount of solar cell panel inspection device 50A. The configuration may have means for concurrently regulating the moisture amount and reducing the moisture amount of both housings 51 A, 53 provided respectively to solar cell panel inspection device 50A and device 52 placed on upstream side thereof. Further, more preferably, a device located on upstream side in the conveyance direction further than upstream side device 52, such as all the conveyers located between the downstream side of the device forming outer peripheral insulating area 21 of the solar cell panel and solar cell panel inspection device 50A, and other devices may have a function of regulating the moisture amount and a function of reducing the moisture amount.

### (Example 1)

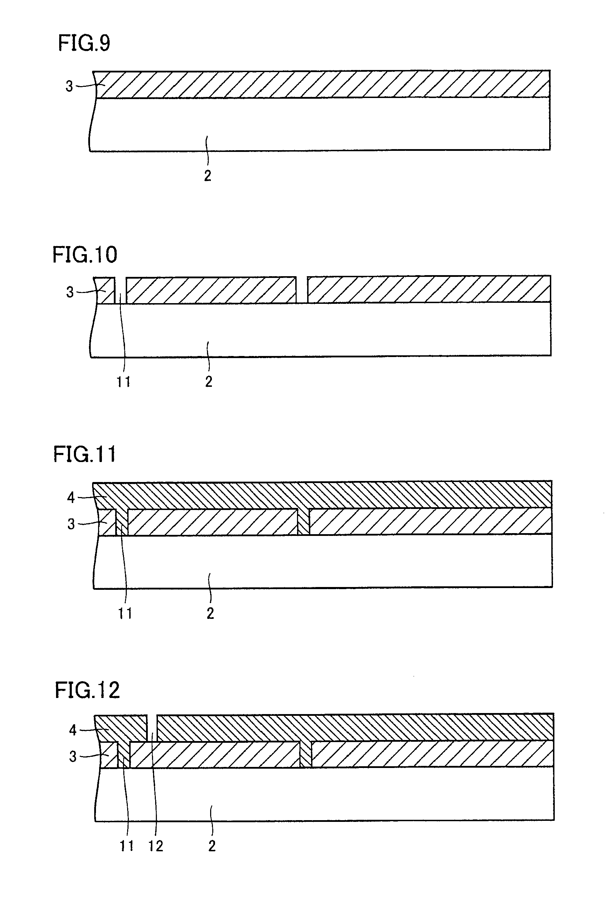

Hereinafter, with reference to Fig. 9 to Fig. 17, a method for manufacturing a solar cell panel including, in manufacturing process, a method for inspecting a solar cell panel using solar cell panel inspection device 50 of the first embodiment will be described, as an example of a method for manufacturing a photoelectric conversion device of the present invention. In the drawings of the present invention, the same reference numerals represent the same part or corresponding part.

Firstly, as shown in the schematic cross-sectional view of Fig. 9, a tin oxide as a transparent conductive film 3 was formed on insulating substrate 2 by a heat CVD method. As the method for forming transparent conductive film 3, for example, conventionally used method such as a sputtering method, a deposition method, or an ion plating method can be used.

Herein, as transparent insulating substrate 2, a glass substrate (with a size of 1000mm X 1400mm, and a thickness of 4mm) was used. Other than the above, for example, a resin substrate including a transparent resin such as a polyimide resin, or a transparent substrate capable of allowing light to pass through, such as a substrate formed by stacking a plurality of these substrates can be used.

Further, as transparent conductive film 3, a film other than the above, such as a single layer of an ITO (Indium Tin Oxide) film or a ZnO (zinc oxide), or a conductive multi-layered film formed by stacking a plurality of these films and capable of allowing light to pass through may be used. When transparent conductive film 3 is configured by a plurality of layers, all the layers may be formed of the same material or formed of layers having at least one layer made of material different from the others.

Herein, the description was provided starting from the step of forming transparent conductive film 3 on transparent insulating substrate 2. However, transparent insulating substrate 2 formed in advance with transparent conductive film 3 may be used. In such a case, the step of forming transparent electrode film 3 is not included in the manufacturing method.

Next, as shown in the schematic cross-sectional view of Fig. 10, a linear first separation groove 11 separating transparent conductive film 3 is formed using a fundamental wave of a YAG laser beam. As a laser beam used for forming first separation groove 11 by a laser scribe method, other laser such as a fundamental wave of a YVO₄ laser beam and a fiber laser can be used.

Next, as shown in the schematic cross-sectional view of Fig. 11, after conducting an ultrasonic cleaning using pure water, photoelectric conversion layer 4 is formed by a plasma CVD method on transparent conductive film 2 formed with first separation groove 11.

As photoelectric conversion layer 4, a semiconductor photoelectric conversion layer can be used. From the side of transparent insulating substrate 2, there are formed a top cell (first photoelectric conversion layer) and a bottom cell (second photoelectric conversion layer) formed on the top cell. The top cell is formed by stacking, in overlaying orders, a p-layer, an i-layer, and an n-layer, made of an amorphous silicon thin film. The bottom cell is formed by stacking, in overlaying orders, a p-layer, an i-layer, and an n-layer, made of a microcrystalline silicon thin film.

Further, as an example of photoelectric conversion layer 4 other than the above, from the side of transparent insulating substrate 2, there may be formed a top cell (first photoelectric conversion layer) having, in overlaying orders, a p-layer, an i-layer, and an n-layer made of an amorphous silicon thin film, a middle cell (second photoelectric conversion layer) having, in overlaying orders, a p-layer, an i-layer, and an n-layer made of an amorphous silicon thin film on the top cell, and a bottom cell (third photoelectric conversion layer) having, in overlaying orders, a p-layer, an i-layer, and an n-layer made of a microcrystalline silicon thin film on the middle cell, by a plasma CVD method, for example. The number of photoelectric conversion layer may be equal to or more than the above.

Each of the photoelectric conversion layers from the first photoelectric conversion layer to the third photoelectric conversion layer may be made of the same kind of silicon-based semiconductor, or may be made of different kinds of silicon-based semiconductors. Each of the photoelectric conversion layers from the first photoelectric conversion layer to the third photoelectric conversion layer includes a p-type semiconductor layer, an i-type semiconductor layer, and an n-type semiconductor layer, and each semiconductor layer may be of a silicon-based semiconductor.

Each of the semiconductor layers included in the photoelectric conversion layer may be of the same kind of silicon-based semiconductor or may be of different kinds of semiconductors. For example, the p-type semiconductor layer and the i-type semiconductor layer may be formed of amorphous silicon, and the n-type semiconductor layer may be formed of microcrystalline silicon. Further, for example, the p-type semiconductor layer and the n-type semiconductor layer may be formed of silicon carbide or silicon germanium, and the i-type semiconductor layer may be formed of silicon.

Further, each semiconductor layer of p-type, i-type, and n-type may have a single-layer structure or a multi-layer structure. When the semiconductor layer has a multi-layer structure, each layer may be of a silicon-based semiconductor of a different kind. In the specification, the term "amorphous silicon" includes "amorphous silicon hydride", and the term "microcrystalline silicon" includes "microcrystalline silicon hydride."

Next, as shown in the schematic cross-sectional view of Fig. 12, a linear second separating groove 12 separating photoelectric conversion layer 4 of solar cell substrate 20 is formed using a second harmonic of a YAG laser beam. A second harmonic of a YVO₄ laser beam may also be used.

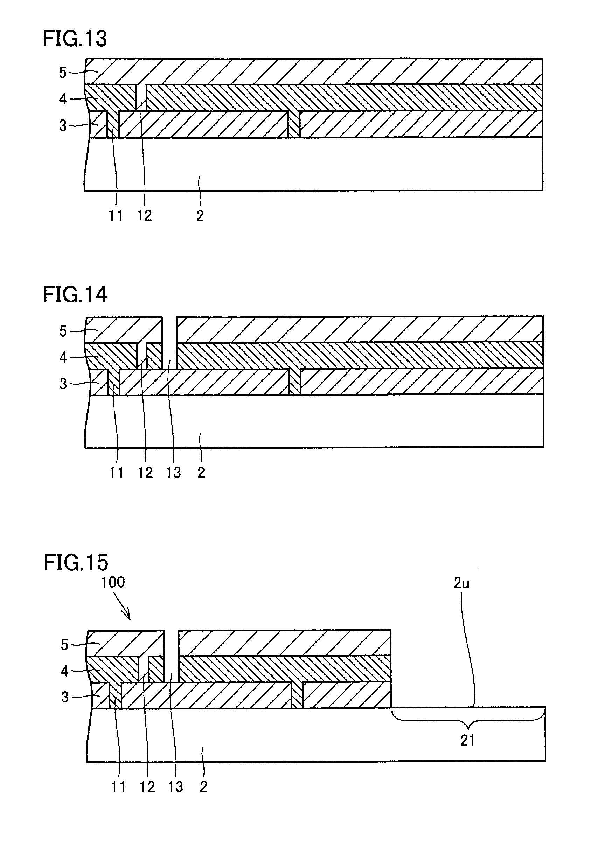

Next, as shown in the schematic cross-sectional view of Fig. 13, back-side electrode layer 5 is formed by the sputtering method so as to cover photoelectric conversion layer 4 formed with second separating groove 12, with a zinc oxide (ZnO)/Ag having a film thickness of 50nm/150nm. As a method for forming back-side electrode layer 5, other methods such as a deposition method or an ion plating method having been conventionally known.

Here, as back-side electrode layer 5, other conductive layer such as an Ag (silver) layer, an Al (aluminum) layer, or a stack of these layers may be used. Further, in view of enhancing a conversion efficiency of a thin-film solar cell, back-side electrode layer 4 preferably has a transparent conductive film allowing a light to pass through and being conductive, such as an SnO₂ film, an ITO film, a ZnO film, or a single layer of film formed by adding a small amount of impurities to these films, or a plurality of layers formed by stacking these films, at a surface on the side of photoelectric conversion layer 4. When the transparent conductive film is constituted by a plurality of layers, all the layers may be formed of the same material, or at least one layer may be formed of material different from other layer.

Then, as shown in the schematic cross-sectional view of Fig. 14, a linear third separating groove 13 separating photoelectric conversion layer 4 and back-side electrode layer 5 is formed using a second harmonic of a YAG laser beam. A second harmonic of a YVO₄ laser beam may also be used.

On this occasion, when forming third separating groove 13, preferably, a forming condition should be selected capable of preventing a damage to transparent electrode layer 3 and suppressing occurrence of a burr at back-side electrode layer 5 after formation of third separating groove 13.

Next, as shown in the schematic cross-sectional view of Fig. 15, outer peripheral insulating area 21 is formed using a fundamental wave of a YAG laser beam. Other than this, a fundamental wave of a YVO₄ laser beam may also be used. Thereafter, a leakage in the solar cell is eliminated by applying inverse voltage with an inverse bias processing device.

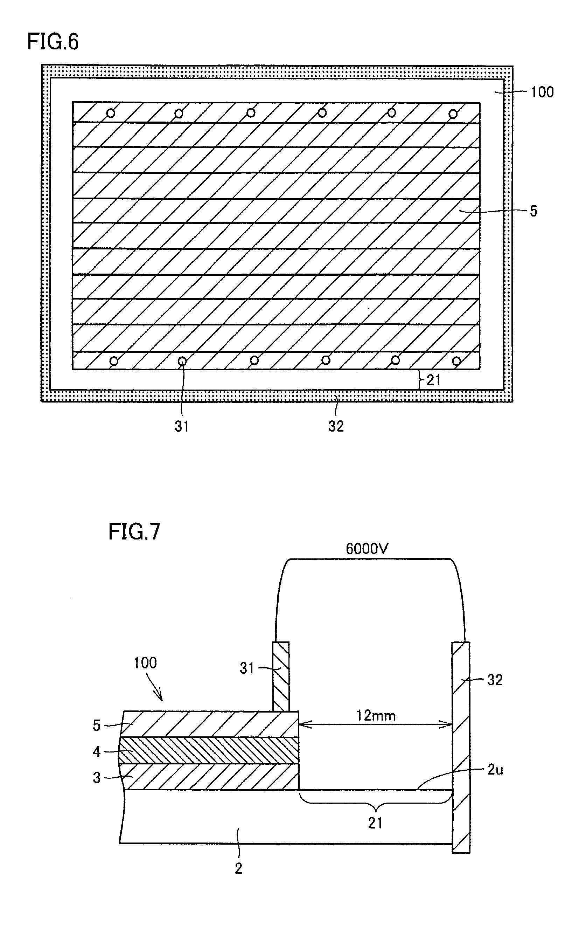

Next, in order to evaluate an insulation breakdown voltage of outer peripheral insulating area 21 formed in solar cell panel 100, an inspection is conducted using solar cell panel inspection device 50 corresponding to the first embodiment. As shown in Fig. 6, six columnar terminals are provided as first terminal 31 of solar cell panel inspection device 50. Second terminals 32 are arranged so as to be in close contact with the outer periphery of solar cell panel 100 subject to inspection and surround the outer periphery in a rectangular shape. First terminals 31 are arranged at positions along two parallel sides in an inner side of the area where back-side electrode layer 5 of solar cell panel 20 is provided.

As shown in Fig. 7, outer peripheral insulating area 21 has a width of 12mm. The voltage of 6000V is applied between first terminals 31 and second terminal 32. Here, insulation breakdown voltage characteristic means the characteristic in that discharging does not occur between a frame attached to the outer peripheral edge of the thin-film solar cell and a thin-film solar cell even when a prescribed high voltage is applied between the frame and the thin-film solar cell.

For example, the insulation breakdown voltage test established in C8991 of Japan Industrial Standard (JIS) is used to test whether a prescribed insulation breakdown voltage characteristic is achieved. In the case of a thin-film solar cell module having the system voltage of 1000V, the insulation breakdown voltage characteristic with respect to the lightning surge of 6KV is required according to the international standard. In the case of a thin-film solar cell having the system voltage of 1000V, it is determined to be acceptable when a current value is less than 50µA at the time of application of 6000V.

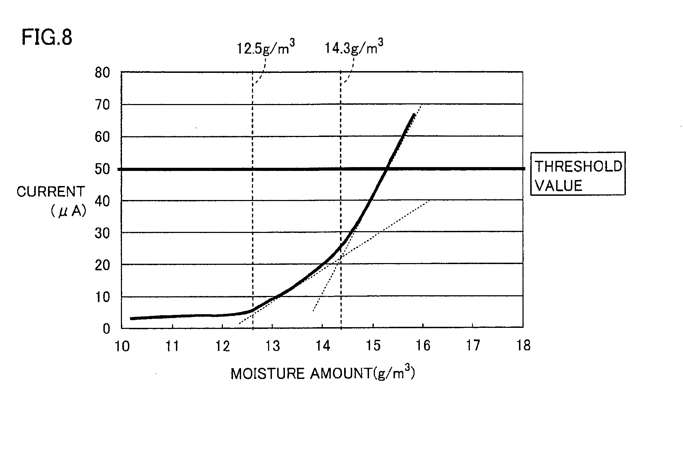

Fig. 8 is a graph showing relationship between the moisture amount in housing 50A and the current amount obtained as a result of the insulation breakdown voltage test for solar cell panel 100 conducted under the above-described condition. The moisture amount is preferably set to be equal to or less than 14.3g/m³ at which a gradient of the amount of flow of current changes, and more preferably regulated under the condition equal to or less than 12.5g/m³ at which point a gradient of the amount of flow of current changes.

In order to maintain the moisture amount in housing 50A to be always at 12.5g/m³, the moisture amount is regulated using means 36A for regulating the moisture amount and means 37A for reducing the moisture amount so that the humidity becomes equal to or less than 57.5% at the temperature of 24°C, equal to or less than 54.5% at the temperature of 25 °C, equal to or less than 51.5% at the temperature of 26 °C, equal to or less than 48.5% at the temperature of 27 °C, and equal to or less than 46% at the temperature of 28 °C. Consequently, during normal conveyance of the solar cell panel, no abnormal inspection result has been obtained. Further, a hundred pieces of solar cell panels 100 were sampled. However, no difference was observed between the first measurement result and the measurement result of re-measurement. Then, using a solar simulator device, characteristics of solar cell panel 100 were measured.

Herein, in a state where solar cell panel 100 (transparent insulating substrate 2) subject to inspection is accommodated in housing 50A, the moisture amount in the atmosphere around solar cell panel 100 is regulated by means 36A for regulating the moisture amount, and the moisture amount in the atmosphere surrounding solar cell panel 100 (transparent insulating substrate 2) is reduced by means 37A for reducing the moisture amount.

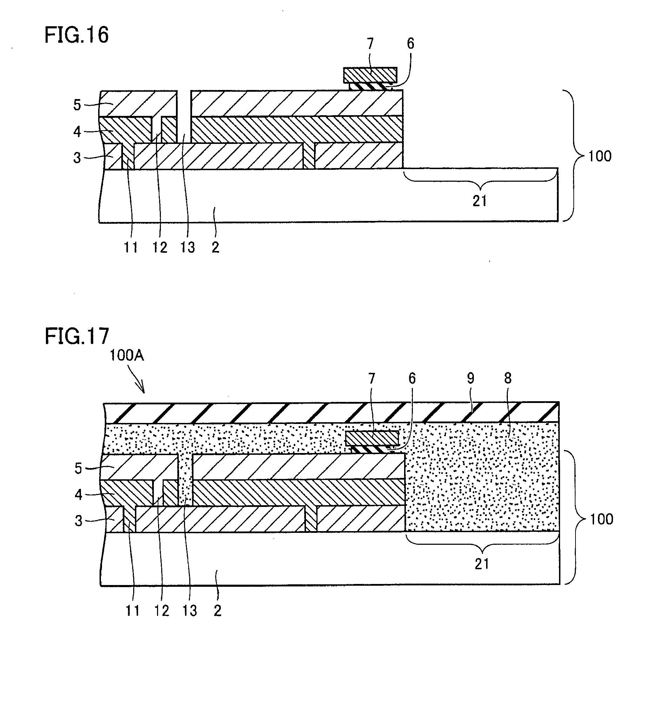

Next, as shown in the schematic cross-sectional view of Fig. 16, a current extracting electrode 7 was formed on a surface of back-side electrode layer 5 through a conductive paste 6 such as a silver paste. After that, as shown in the schematic cross-sectional view of Fig. 17, a transparent adhesive 8 made of a transparent EVA (ethylene-vinyl acetate) was placed on the surface of back-side electrode layer 5 formed with electrode 7 and on a back side of the above-described layer stack. Then, after placing a back-side sealing member 9 formed of a layer stack film including PET (polyester) / aluminum / PET, back-side sealing member 9 and transparent insulating substrate 2 were bonded by a vacuum laminating device.

Thereafter, a terminal box (not shown) was bonded to back-side sealing member 9 of solar cell panel 100, and the terminal box is filled with a silicone resin, and then an aluminum frame (not shown) was attached, so that thin-film solar cell 100A using solar cell panel 100 is completed.

For thin-film solar cell 100A fabricated in the manner described above, after attaching the aluminum frame at the location corresponding to outer peripheral insulating area 21 of solar cell panel 100, the voltage of 6000V is applied between the aluminum frame and electrode 7 of thin-film solar cell 100A to conduct the final insulation breakdown voltage test. As a result, all of the cells were accepted.

### (Example 2)

A method for manufacturing a solar cell panel having manufacturing steps including a method for inspecting a solar panel using solar cell panel inspection device 50A in accordance with the second embodiment, and a method for manufacturing a thin-film solar cell using the solar cell panel will be described. Only the matters different from the Example 1 will be described. Upstream side device 52 having a conveyer on upstream side in the direction of conveying solar panel 100 of solar cell panel inspection device 50A is provided, and means 36A for regulating the moisture amount and means 37A for reducing the moisture amount is provided also in housing 53 of upstream side device 52.

In the case of not providing means 37A for reducing the moisture amount to upstream side device 52, when a trouble occurs in the step after the use of solar cell panel inspection device 50A, causing conveyance of solar cell panel 100 to be held and the conveyance line is stopped, sometimes the inspection cannot be conducted. The following is considered as causes of the problem described above.

In the step prior to the use of solar cell panel inspection device 50A, when the moisture amount is high, and the moisture is absorbed on outer peripheral insulating area 21 of solar cell panel 100, the measurement value of solar cell panel inspection device 50A was influenced. This is possibly because the regulation for the moisture amount in solar cell panel inspection device 50A is not sufficient since it takes a long time to remove the moisture absorbed on outer peripheral insulating area 21.

On the other hand, by providing means 36A for regulating the moisture amount and means 37A for reducing the moisture amount also in upstream side device 52 to regulate the moisture amount in upstream side device 52 located on upstream side of solar cell panel inspection device 50A, the measurement could be accurately conducted even when a trouble occurs.

It should be understood that the embodiments and examples disclosed herein are illustrative and non-restrictive in every respect. The scope of the present invention is defined by the terms of claims, and is intended to include any modifications within the scope and meaning equivalent to the terms of the claims.

### REFERENCE SIGNS LIST

2 transparent insulating substrate; 2u main surface; 3 transparent electrode layer; 4 semiconductor photoelectric conversion layer; 5 back-side electrode layer; 6 conductive paste; 7 current extracting electrode; 8 transparent adhesive; 9 back-side sealing member; 21 outer peripheral insulating area; 31 first terminal; 32 second terminal; 33 third terminal; 34 voltage applying section; 35 current detecting section; 36, 36A regulating moisture amount; 37, 37A means for reducing moisture amount; 38, 38A controller; 39, 39A conveying means; 50 solar cell panel inspection device; 50A solar cell panel inspection device; 51 housing; 52 upstream side device; 100 solar cell panel; 100A thin-film solar cell.

## Claims

1. A solar cell panel inspection device for performing inspection with respect to a solar cell panel (100), said solar cell panel (100) including a transparent electrode layer (3), a photoelectric conversion layer (4), and a back-side electrode layer (5) sequentially stacked on a main surface of a transparent insulating substrate (2), and having an outer peripheral insulating area (21) located in proximity to an outer periphery of said transparent insulating substrate (2) and exposing said main surface of said transparent insulating substrate (2), and said solar cell panel inspection device is for inspecting insulation performance of said outer peripheral insulating area (21), the solar cell panel inspection device comprising:
a housing (51) accommodating said solar cell panel (100) subject to inspection;
a first terminal (31) for abutting against said back-side electrode layer (5);
a second terminal (32) for abutting against a region in proximity to an outer peripheral end of said outer peripheral insulating area (21);
a voltage applying section (34) applying voltage respectively between said first terminal (31) and said second terminal (32);
a current detecting section (35) detecting a current flowing between said first terminal (31) and said second terminal (32) applied with voltage by said voltage applying section (34); and
means (37) for reducing moisture amount in said housing (51).

2. The solar cell panel inspection device according to claim 1, wherein said means (37) for reducing the moisture amount includes a drying air.

3. The solar cell panel inspection device according to claim 1, wherein said means (37) for reducing the moisture amount includes a dehumidifier.

4. The solar cell panel inspection device according to claim 1, wherein said means (37) for reducing the moisture amount includes a drying agent.

5. The solar cell panel inspection device according to claim 1, further comprising means (36) for regulating the moisture amount in said housing (51).

6. The solar cell panel inspection device according to claim 5, wherein said means (36) for regulating the moisture amount regulates temperature and humidity in said housing (51).

7. The solar cell panel inspection device according to claim 5, wherein said means (36) for regulating moisture amount regulates humidity at a maximum temperature in said housing (51).

8. The solar cell panel inspection device according to claim 5, wherein said moisture amount is regulated to be equal to or lower than 14.3g/m³.

9. A method for inspecting a solar cell panel (100), said solar cell panel including a transparent electrode layer (3), a photoelectric conversion layer (4), and a back-side electrode layer (5) sequentially stacked on a main surface of a transparent insulating substrate (2) and having an outer peripheral insulating area (21) located in proximity to an outer periphery of said transparent insulating substrate (2) and exposing said main surface of said transparent insulating substrate (2), the method for inspect insulation performance of said outer peripheral insulating area (21), comprising the steps of:
reducing moisture amount in an atmosphere around said solar cell panel (100) subject to inspection; and
detecting a current flowing between said back-side electrode layer (5) and a location in proximity to an outer peripheral end of said outer peripheral insulating area (21) after the step of reducing the moisture amount.

10. A solar cell panel including a transparent electrode layer (3), a photoelectric conversion layer (4), and a back-side electrode layer (5) sequentially stacked on a main surface (2u) of a transparent insulating substrate (2) and having an outer peripheral insulating area (21) located in proximity to an outer periphery of said transparent insulating substrate (2) and exposing said main surface (2u) of said transparent insulating substrate (2), said solar cell panel (100) manufactured by using a solar cell panel inspection method for inspecting insulation performance of said outer peripheral insulating area (21),
said solar cell panel inspection method including the steps of:
reducing moisture amount in an atmosphere around said solar cell panel (100) subject to inspection; and
detecting a current flowing between said back-side electrode layer (5) and a location in proximity to an outer peripheral end of said outer peripheral insulating area (21) after the step of reducing the moisture amount.

11. A method for manufacturing a solar cell panel, comprising the steps of:
stacking a photoelectric conversion layer (4) and a back-side electrode layer (5) onto a transparent electrode layer (3) provided on a transparent insulating substrate (2);
forming an outer peripheral insulating area (21) by removing said transparent electrode layer (3), said photoelectric conversion layer (4), and said back-side electrode layer (5) stacked in proximity to an outer periphery of said transparent insulating substrate (2);
reducing a moisture amount in an atmosphere around said transparent insulating substrate (2); and
inspecting insulation performance of said outer peripheral insulating area (21) by detecting a current flowing between said back-side electrode layer (5) and a region in proximity to an outer peripheral end of said outer peripheral insulating area (21) after the step of reducing a moisture amount.

12. A solar cell panel manufactured by using a method for manufacturing a solar cell panel,
said method for manufacturing a solar cell panel including the steps of:
stacking a photoelectric conversion layer (4) and a back-side electrode layer (5) on a transparent electrode layer (3) provided at a transparent insulating substrate (2);
forming an outer peripheral insulating area (21) by removing said transparent electrode layer (3), said photoelectric conversion layer (4), and said back-side electrode layer (5) stacked in proximity to an outer periphery of said transparent insulating substrate (2);
reducing a moisture amount in an atmosphere around said transparent insulating substrate (2); and
inspecting insulation performance of said outer peripheral insulating area (21) by detecting a current flowing between said back-side electrode layer (5) and a location in proximity to an outer peripheral end of said outer peripheral insulating area (21) after the step of reducing the moisture amount.
